# DEMANDE DE BREVET EUROPEEN

(11) **EP 1 170 857 A2**
(43) Date de publication de la demande: **09.01.2002**
(21) Numéro de dépôt: 01201476.7
(22) Date de dépôt: 24.04.2001
(51) Int. Cl.: H03B 21/02

(54) **Appareil électronique comportant un circuit multiplicateur de fréquences, circuit multiplicateur de fréquences et procédé pour multiplier en fréquence des signaux**

(30) Priorité: 03.05.2000 FR 0005640
(71) Demandeur: Koninklijke Philips Electronics N.V., 5621 BA Eindhoven (NL)
(72) Inventeur: Wang, Zhenhua, 75008 Paris (FR)
(74) Mandataire: Chaffraix, Jean

(57) **Abrégé**

Cet appareil électronique comporte un générateur de signaux périodiques (12) et un circuit multiplicateur de fréquences (14) pour multiplier la fréquence de ces signaux périodiques. Ce circuit multiplicateur (14) est constitué à partir d'une porte de type " OU-EXCLUSIF " (20) recevant lesdits signaux périodiques et d'un circuit diviseur de fréquence (22) connecté entre la sortie et une entrée de ladite porte. De ce circuit diviseur, il est possible de dériver très facilement des signaux en quadrature ce qui permet de faire une démodulation du type connu sous le nom de " 0-démodulation ".

D'une manière avantageuse, ce circuit multiplicateur (14) est réalisé selon la technologie CML " Current Mode Logic ".
Application à la transmission d'informations.

## Description

L'invention concerne un appareil électronique comportant un générateur de signaux périodiques et au moins un circuit multiplicateur de fréquences pour multiplier leur fréquence constitué à partir d'une porte de type " OU-EXCLUSIF " recevant lesdits signaux périodiques.

L'invention concerne aussi un circuit multiplicateur de fréquences proprement dit convenant à un tel appareil.

L'invention concerne encore un procédé pour multiplier en fréquences des signaux d'horloge.

L'invention trouve d'importantes applications notamment dans le domaine des télécommunications utilisant des fréquences élevées.

Un tel appareil est connu du document de brevet US 5,864,246. Il est proposé dans ce document de brevet de faire appel à un organe de déphasage qui fournit une réplique retardée du signal d'horloge de sorte qu'une porte OU-EXCLUSIF, en combinant les signaux d'horloge et la réplique, fournit le signal à fréquence double.

L'appareil connu de ce document présente l'inconvénient que les répliques de signaux judicieusement déphasées aux fréquences élevées ne sont pas facile à réaliser, notamment aux fréquences élevées et sont donc coûteuses à réaliser.

La présente invention propose un appareil du genre mentionné dans le préambule qui évite la présence de tels organes de déphasage.

Pour cela, un tel appareil est remarquable en ce que ce circuit comporte un circuit diviseur de fréquence connecté entre la sortie et une entrée de ladite porte.

Selon un mode de réalisation préféré de l'invention, un tel appareil est remarquable en ce que ledit circuit multiplicateur comporte des sorties pour fournir des signaux déphasés de 90° à la fréquence desdits signaux périodiques.

Ce mode de réalisation apporte l'avantage qu'il devient facile et à moindre coût de réaliser des démodulations connues sous le nom de " 0-démodulation ".

La description suivante, faite en regard des dessins ci-annexés, le tout donné à titre d'exemples non limitatifs fera bien comprendre comment l'invention peut être réalisée. Sur les dessins :
La figure 1 montre un appareil conforme à l'invention.
La figure 2 montre le schéma d'un circuit multiplicateur de fréquences conforme à l'invention.
La figure 3 montre un diagramme temps explicitant le fonctionnement du circuit multiplicateur de fréquences.
La figure 4 montre un autre appareil conforme à l'invention.
La figure 5 montre un circuit multiplicateur de fréquences utilisé dans l'appareil montré à la figure 4.
La figure 6 montre un diagramme temps explicitant le fonctionnement du circuit multiplicateur de fréquences montré à la figure 4.
La figure 7 montre un exemple de réalisation d'un circuit multiplicateur de fréquences du type montré à la figure 4, réalisé en logique dite CML (Current-Mode Logic).

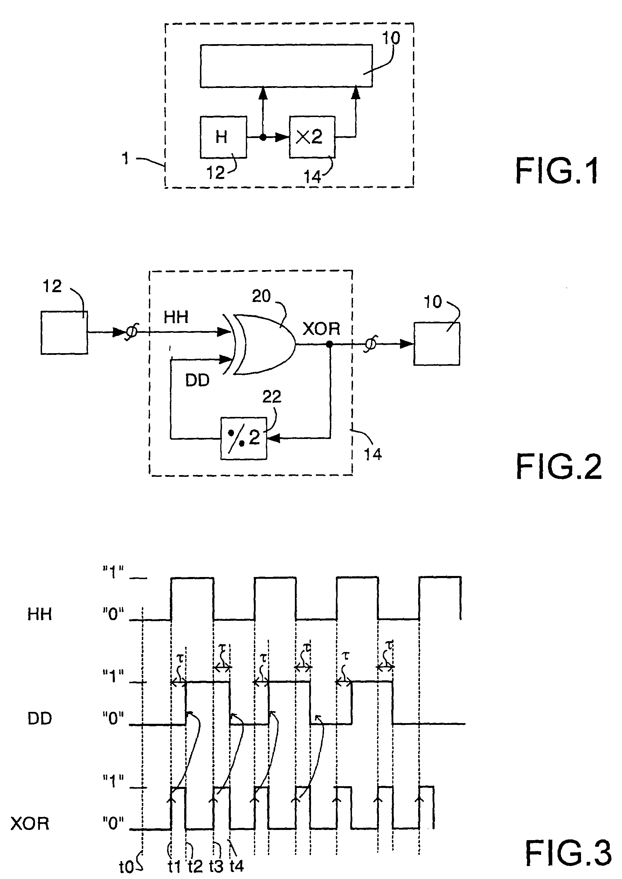

La figure 1 montre un appareil conforme à l'invention qui porte la référence 1. Cet appareil 1 comporte par exemple une tête de réception 10 recevant des signaux à hautes fréquences. Cette tête nécessite un oscillateur local à fréquence élevée. Pour obtenir cette fréquence, on utilise un générateur de signaux périodiques 12 et au moins un circuit doubleur de fréquence 14

La figure 2 montre un schéma électrique du circuit diviseur de fréquence 14. Il se compose d'une porte " OU-EXCLUSIF " portant la référence 20. Cette porte comporte une sortie pour fournir, dans cet exemple décrit, le signal à fréquence double et deux entrées. Une première reçoit le signal dont la fréquence doit être doublée, elle est donc reliée à la sortie du générateur 12 et conformément à l'invention, la deuxième entrée est reliée à la sortie par l'intermédiaire d'un diviseur de fréquence 22.

Le fonctionnement du circuit 14 est expliqué en s'aidant de la figure 3. Cette figure est un diagramme temps des différents signaux présents sur ce circuit. La ligne HH représente les signaux présents sur la première entrée de la porte 20. La ligne DD représente l'allure des signaux présents à la deuxième entrée et la ligne XOR les signaux fournis par le circuits 14, donc à la sortie de la porte 20.

On considère un instant t0 où la valeur de chacun des signaux HH, DD et XOR est égale à " 0 " et on suppose que le diviseur de fréquence 22 est initialisé et que la valeur de son signal de sortie changera de valeur pour chaque front montant du signal appliqué à son entrée, ce signal étant le signal XOR.

A l'instant t1, le signal HH prend la valeur " 1 " ce qui entraîne que le signal XOR prend aussi la valeur " 1 ". Cette première transition montante du signal XOR va modifier à l'instant t2 le signal de sortie du diviseur 22. Cet instant t2 survient après une durée τ égale au temps de transfert du diviseur 22. Dès que le signal D à la sortie du diviseur 22 prend la valeur " 1 ", il y a inversion du signal HH de sorte que le signal XOR prend la valeur " 0 ". A l'instant t3, une transition du signal HH survient, donc le signal XOR change de valeur provoquant une transition montante au temps t4, après le temps τ, ce qui fait changer d'état le signal à la sortie du diviseur 22. Ainsi, le signal XOR est un signal à fréquence double de celle du signal HH.

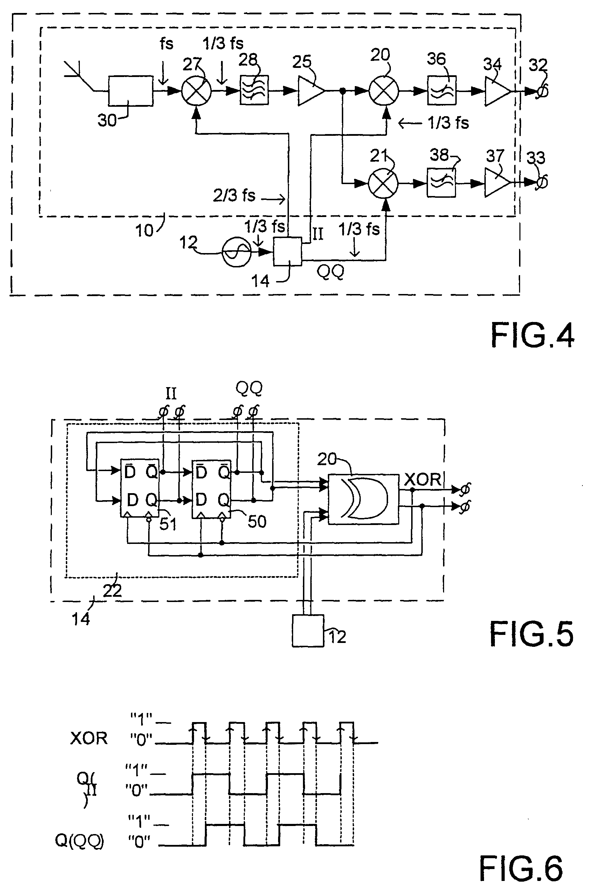

La figure 4 montre un autre appareil conforme à l'invention. Ce genre d'appareil est décrit, par exemple dans la spécification du circuit UAA3500HL fabriqué par Philips Semicondutors. La tête de réception 10 de cet appareil comporte essentiellement un démodulateur connu sous le nom de " 0-démodulateur ". Pour obtenir cette démodulation, on utilise deux mélangeurs 20 et 21 qui reçoivent les signaux à démoduler provenant d'un amplificateur 25. La fréquence porteuse de ces signaux à l'entrée des mélangeurs 20 et 21 est égale à 1/3 fs. Ces signaux sont mélangés avec des signaux locaux dont la fréquence est aussi égale à 1/3 fs mais en quadrature de phase. Les signaux appliqués à ces mélangeurs ont subi un changement de fréquence effectué par un mélangeur 27 et un filtrage par le filtre 28. Le mélangeur 27 reçoit les signaux à démoduler transmis avec une porteuse égale à fs, pour donner à cette porteuse la valeur 1/3 fs. Ces signaux à porteuse fs proviennent du premier étage 30 de la tête 10. Les signaux fournis par cette tête 10 sont rendus disponibles aux bornes 32 et 33. La borne 32 est reliée à la sortie du mélangeur 20 par l'intermédiaire d'un amplificateur 34 et d'un filtre 36, tandis que la borne 33 est reliée à la sortie du mélangeur 21 par l'intermédiaire d'un amplificateur 37 et d'un filtre 38.

Les signaux fournis aux mélangeurs 20, 21 et 27, sont fournis par le circuit multiplicateur de fréquence 14 réalisé conformément à l'invention et qui fournit, en outre, sans trop de dépenses supplémentaires les signaux II et QQ en quadrature de phase aux mélangeurs 20 et 21. Le circuit multiplicateur 14 utilise les signaux provenant de l'oscillateur 12 dont la fréquence d'oscillation est égale à 1/3 fs.

La figure 5 montre la structure du circuit multiplicateur de fréquences 14. Il fonctionne systématiquement sur les signaux et ses compléments ce qui est une caractéristique de la logique CML déjà mentionnée. La porte 20 travaille donc avec des signaux complémentaires. Le diviseur 22 est composé de deux bascules 50 et 51 de type D prenant aussi en compte les signaux complémentaires. Le signal II est prélevé aux sorties de la bascule 51 et le signal QQ à la sortie de la bascule 50. C'est ce signal QQ qui est appliqué aux premières entrées du circuit " OU-EXCLUSIF " 20. Les entrées d'horloge de ces bascules sont reliées aux sorties du circuit 20.

Le diagramme temps de la figure 6 explicite la formation des signaux Q(II) et Q(QQ) aux sorties des bascules 51 et 50. Le signal dont on divise la fréquence est le signal XOR disponible en sortie du circuit 20. Comme ces bascules sont actives aux fronts montants et descendants, les signaux sont déphasés d'un front actif. Si le rapport cyclique du signal XOR est égal à 0,5 (c'est-à-dire que la durée pendant laquelle ce signal a une valeur " 0 " est égale à la durée pendant laquelle le signal a la valeur " 1 "), alors on a un déphasage égal à π/2. Ceci peut être obtenu en faisant jouer, par exemple, le paramètre τ.

Bien qu'on ait représenté les différents signaux sous forme rectangulaire, ces signaux ont en fait une allure sinusoïdale due au fait que, d'une part, ces signaux sont de fréquence élevée et que, d'autre part, ces circuits présentant une limitation en fréquence haute d'une manière inhérente, ne laissent pas passer les harmoniques de rangs élevés des signaux.

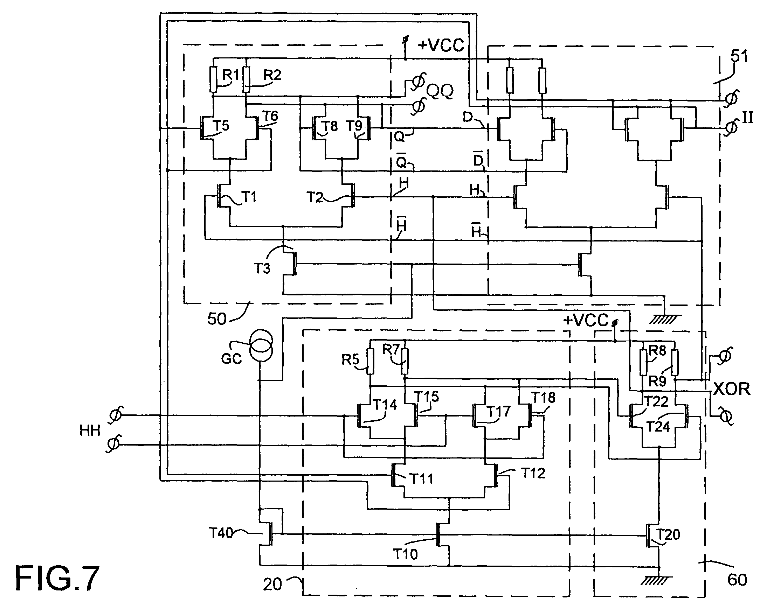

La figure 7 montre le schéma de réalisation préféré d'un circuit multiplicateur de fréquences réalisé en logique CML (Current-Mode Logic).

Les bascules 50 et 51 ont des structures identiques et on expliquera seulement la structure de la bascule 50. Elle est formée d'un premier montage symétrique constitué par les transistors T1 et T2 dont l'électrode de source est reliée au drain d'un transistor T3. La grille de ce transistor T3 est alimentée par un générateur de courant GC. Chacun des transistors T1 et T2 alimente une paire de transistors T5 etT6 pour le premier et T8 et T9 pour le second. Les drains des transistors T5 et T9 sont reliés à une résistance R1, tandis que les drains des transistors T6 et T9 sont reliés à une résistance R2. Les extrémités de ces résistances qui ne sont pas reliées aux drains reçoivent la tension d'alimentation VCC. Les signaux complémentaires QQ sont prélevés aux points communs des résistances avec le drain des transistors qui leur sont rattachés. Ces sorties QQ sont reliées aux entrées H de la bascule 51. Les entrées H de la bascule 50 sont constituées par les grilles des transistors T1 et T2, le transistor T3 coopérant avec le générateur de courant GC alimente en courant les sources des transistors T1 et T2.

Le circuit " OU-EXCLUSIF " 20 est formé d'un premier transistor T10 dont la source est reliée à la masse comme celle du transistor T3 et dont le drain est relié aux sources de deux transistors T11 et T12 dont les grilles reçoivent les signaux II. Les drains des transistors T11 et T12 sont reliés à deux paires de transistors respectivement, à savoir les transistors T14 et T15 pour la première paire et les transistors T17 et T18 pour la seconde. Les drains des transistors T14 et T17 sont reliés à une extrémité d'une résistance R5 dont l'autre extrémité reçoit la tension d'alimentation VCC. De la même manière les drains des transistors T15 et T18 sont reliés à une extrémité d'une autre résistance R7 dont l'autre extrémité reçoit aussi la tension d'alimentation VCC. Les grilles des transistors T14, T15, T17 et T18 reçoivent les signaux HH dont on veut multiplier la fréquence. Les signaux de sortie de ce circuit 20 prélevés aux points communs des résistances R5 et R7 avec le drain des transistors qui leur sont rattachés sont reliés aux entrées d'un amplificateur tampon 60.

Cet amplificateur 60 est formé par une paire de transistors montés en paire différentielle alimentée en courant par un transistor T20. La paire est formée de deux transistors T22 et T24 dont les sources sont reliées au drain du transistor T20 et dont les drains sont reliés aux premières extrémités de résistances R8 et R9. Les autres extrémités de ces résistances reçoivent la tension d'alimentation VCC. Les grilles de ces transistors constituent l'entrée de cet amplificateur 60 tandis que leur drains constituent la sortie. Les grilles des transistors T3, T10 et T20 sont reliées à la grille d'un transistor T40 dont le drain est connecté à la fois à sa grille et au générateur de courant GC pour constituer ainsi un miroir de courant.

Il est à noter que le circuit multiplicateur de fréquences peut fonctionner avec des taux de multiplication différents de deux ainsi qu'il a été décrit en changeant le rapport de division du diviseur de fréquences.

## Revendications

1. Appareil électronique comportant un générateur de signaux périodiques et au moins un circuit multiplicateur de fréquences pour multiplier leur fréquence constitué à partir d'une porte de type " OU-EXCLUSIF " recevant lesdits signaux périodiques, **caractérisé en ce que** ce circuit comporte un circuit diviseur de fréquences connecté entre la sortie et une entrée de ladite porte.

2. Appareil selon la revendication 1, **caractérisé en ce que** ledit circuit multiplicateur comporte deux sorties pour fournir des signaux déphasés de 90° à ladite fréquence des signaux périodiques.

3. Appareil selon la revendication 2, **caractérisé en ce que** lesdites sorties sont constituées par des points de branchement du circuit diviseur de fréquences.

4. Appareil selon l'une des revendications 1 à 3, **caractérisé en ce que** ledit circuit multiplicateur de fréquences est réalisé en logique dite " CML " (Current-mode Logic).

5. Appareil selon l'une des revendications 1 à 4, **caractérisé en ce que** le circuit diviseur de fréquences est constitué par des bascules munies d'entrées de basculement et dont les états peuvent changer à chaque front montant ou descendant des signaux appliqués à leur entrées de basculement.

6. Appareil selon l'une des revendications 2 à 5, **caractérisé en ce que** lesdites sorties en quadrature sont reliées aux sorties desdites bascules.

7. Circuit multiplicateur de fréquences convenant à un appareil selon l'une des revendications 1 à 6, **caractérisé en ce qu'**il est constitué à partir d'une porte de type " OU-EXCLUSIF " recevant lesdits signaux dont on veut multiplier la fréquence et **en ce qu'**il comporte un circuit diviseur de fréquences connecté entre la sortie et une entrée de ladite porte dont la sortie constitue la sortie dudit circuit multiplicateur et l'autre entrée son entrée.

8. Procédé pour multiplier la fréquence d'un signal mis en oeuvre dans un appareil selon l'une des revendications 1 à 6, **caractérisé en ce qu'**il comporte les étapes suivantes :
- une première opération de type " OU-EXCLUSIF " avec le signal dont on veut multiplier la fréquence et un signal traité en vue de fournir le signal multiplié en fréquence,
- une deuxième opération pour fournir ledit signal traité en divisant la fréquence du signal résultant de la première opération.
